(19) Europäisches Patentamt
European Patent Office
Office européen des brevets

(11) **EP 3 948 409 B1**

(12) **FASCICULE DE BREVET EUROPEEN**

(45) Date de publication et mention de la délivrance du brevet:
**13.03.2024   Bulletin 2024/11**

(21) Numéro de dépôt: **20713320.8**

(22) Date de dépôt: **27.03.2020**

(51) Classification Internationale des Brevets (IPC):
***G02F 1/017*** (2006.01)

(52) Classification Coopérative des Brevets (CPC):
**G02F 1/017;** G02F 1/01783

(86) Numéro de dépôt international:
**PCT/EP2020/058841**

(87) Numéro de publication internationale:
**WO 2020/193786 (01.10.2020 Gazette 2020/40)**

(54) **MODULATEUR ULTRA-RAPIDE DE L'AMPLITUDE D'UN RAYONNEMENT LASER**

ULTRASCHNELLER MODULATOR ZUR MODULATION DER AMPLITUDE VON LASERSTRAHLUNG

ULTRA-FAST MODULATOR FOR MODULATING THE AMPLITUDE OF LASER RADIATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **27.03.2019  FR 1903211**

(43) Date de publication de la demande:
**09.02.2022   Bulletin 2022/06**

(73) Titulaires:
• **Centre national de la recherche scientifique**
  **75016 Paris (FR)**
• **Université Paris-Saclay**
  **91190 Gif-sur-Yvette (FR)**

(72) Inventeurs:
• **COLOMBELLI, Raffaele**
  **94300 VINCENNES (FR)**
• **PIROTTA, Stefano**
  **75014 PARIS (FR)**
• **TRAN, Ngoc Linh**
  **91120 PALAISEAU (FR)**

(74) Mandataire: **IPAZ**
  **Bâtiment Platon**
  **Parc Les Algorithmes**
  **91190 Saint-Aubin (FR)**

(56) Documents cités:
• **CRISTIANO CIUTI ET AL: "Quantum vacuum properties of the intersubband cavity polariton field", ARXIV.ORG, CORNELL UNIVERSITY LIBRARY, 201 OLIN LIBRARY CORNELL UNIVERSITY ITHACA, NY 14853, 1 avril 2005 (2005-04-01), XP080183653, DOI: 10.1103/PHYSREVB.72.115303**
• **SIMONE DE LIBERATO ET AL: "Quantum Vacuum Radiation Spectra from a Semiconductor Microcavity with a Time-Modulated Vacuum Rabi Frequency", PHYSICAL REVIEW LETTERS, vol. 98, no. 10, 1 mars 2007 (2007-03-01), XP055661337, US ISSN: 0031-9007, DOI: 10.1103/PhysRevLett.98.103602**
• **DIMITRI DINI ET AL: "Microcavity Polariton Splitting of Intersubband Transitions", PHYSICAL REVIEW LETTERS, vol. 90, no. 11, 1 mars 2003 (2003-03-01), page 67, XP055661341, US ISSN: 0031-9007, DOI: 10.1103/PhysRevLett.90.116401**
• **MACHHADANI H ET AL: "GaN/AIGaN intersubband optoelectronic devices", NEW JOURNAL OF PHYSICS, INSTITUTE OF PHYSICS PUBLISHING, BRISTOL, GB, vol. 11, no. 12, 1 décembre 2009 (2009-12-01), page 125023, XP020169428, ISSN: 1367-2630 cité dans la demande**

- **OMRI WOLF ET AL: "Spectral filtering using active metasurfaces compatible with narrow bandgap III-V infrared detectors", OPTICS EXPRESS, vol. 24, no. 19, 7 septembre 2016 (2016-09-07), page 21512, XP055462841, DOI: 10.1364/OE.24.021512**

**Description**

**Domaine technique** :

L'invention relève du domaine de la modulation électro-optique et plus particulièrement des modulateurs électro-optiques, notamment dans l'infrarouge.

**Technique antérieure** :

La modulation ultra rapide de l'amplitude d'un rayonnement laser dans l'infrarouge moyen est un domaine d'étude suscitant un fort intérêt particulièrement dans le domaine des télécommunications pour la transmission d'information à l'aide d'une porteuse optique. En effet, avec une porteuse optique possédant une longueur d'onde dans l'une des deux fenêtres atmosphérique ($3-5\,\mu m$ et $8-12\,\mu m$), la théorie de Mie démontre une forte robustesse de la transmission d'information dans l'air vis-à-vis des perturbations atmosphériques (vapeur d'eau, particules atmosphériques...). Cette robustesse est due au fait que la taille moyenne des particules atmosphériques est en général très inférieure à la longueur d'onde de la porteuse.

Un deuxième domaine d'intérêt est la métrologie et la spectroscopie à haute résolution, car une modulation ultra-rapide permet de générer des bandes latérales précisément positionnées en fréquence par rapport à la fréquence de la porteuse.

A l'heure actuelle, les lasers dans l'IR-moyen sont pour la plupart des lasers à cascade quantique. Cependant, dans cette gamme de longueur d'onde, il n'existe pas de source modulable à haute fréquence (sub-GHZ et au-delà) disponible commercialement. Les rares solutions disponibles et proposées dans la littérature scientifique sont encore au stade de démonstrateurs complexes et coûteux, limitant très fortement leurs utilisations et applications.

Il est connu de l'art antérieur de réaliser des modulateurs électro-optiques ultra-rapides dans l'IR-moyen reposant sur le transfert de charge entre deux puits quantiques couplés (Nevou, L., et al. (2007). Short-wavelength intersubband electroabsorption modulation based on électron tunneling between GaN/AIN coupled quantum wells. Applied Physics Letters, 90(22), 223511*). Dans ce dispositif, des puits quantiques de GaN sont couples par une barrière de potentiel ultramince en AIN. Un puits sert de réservoir et un autre, le puits actif, est conçu pour présenter une transition intersousbande (ISB) à la longueur d'onde d'illumination. Sous application d'une tension positive, les électrons sont transférés par effet tunnel du puits réservoir au puits actif et le modulateur devient alors absorbant. Il redevient transparent en appliquant une tension négative qui provoque le retour des électrons dans le puits réservoir. Le mécanisme de transfert de charge étant rapide (quelques picosecondes), le dispositif permet d'obtenir un bon temps de réponse (quelques GHz), cependant, il ne permet d'obtenir qu'une faible profondeur de modulation (environ 30% à $\lambda=2.1\,\mu m$).

Il est aussi connu de réaliser des modulateurs dans l'IR-moyen ultra-rapides reposant sur le peuplement/dépeuplement des puits quantiques sous l'action d'un champ électrique (Machhadani, H., et al, (2009). GaN/AIGaN intersubband optoelectronic devices. New Journal of Physics, 11 (12), 125023*). En insérant une région active composée de trois puits quantiques GaN/AIN dans un guide d'onde en AIGaN, il a été démontré une profondeur de modulation à $1.55\,\mu m$ de $13.5\,dB$ avec une tension de $\pm7V$. Dans ce type de dispositif, la fréquence de réponse n'est limitée que par la constante RC du circuit électrique appliquant une tension de grille permettant de vider les puits quantiques. En effet, l'autre phénomène limitant le temps de réponse est le transfert de charge entre les puits quantiques couplés, qui est très rapide car réalisé par effet tunnel (de l'ordre de quelques picosecondes). Cependant, ce dispositif introduit des pertes importantes par propagation dans le guide d'onde.

Enfin il est connu de l'homme du métier de réaliser un modulateur électro-optique basé sur des empilements de puits quantiques placés dans une microcavité, les puits quantiques étant construits de manière à présenter un important effet Stark quantique confiné (Lee, J., et al.. (2014). Ultrafast Electrically Tunable Polaritonic Metasurfaces. Advanced Optical Materials, 2(11), 1057-1063; CRISTIANO CIUTI ET AL(2005): "Quantum vacuum properties of the intersubband cavity polariton field").

Dans ce dispositif, la modulation est produite par l'application d'un champ électrique entre les deux éléments de la microcavité et au travers de l'empilement de puits quantiques permettant de déplacer les pics d'absorption ISB par effet Stark quantique confiné. Ici aussi, le temps de réponse d'un tel dispositif n'est limité que par la constante RC du circuit électrique. Cependant, la profondeur de modulation reste faible (30% pour $\lambda=7.12\ \mu$m).

L'invention vise à pallier certains problèmes de l'art antérieur. A cet, un objet de l'invention est un modulateur électro-optique basé sur des empilements de puits quantiques placés dans une microcavité utilisant le régime de couplage fort afin d'obtenir un bon temps de réponse du dispositif et une excellente profondeur de modulation.

**Résumé de l'invention** :

A cet effet, un objet de l'invention est un dispositif de modulation de l'amplitude d'un rayonnement laser incident (1) de longueur d'onde $\lambda_i$ caractérisé en ce qu'il comprend : une couche inférieure métallique (3) au-dessus de laquelle se trouve une couche semi-conductrice (4) contient un empilement d'une pluralité de puits quantiques, au-dessus de laquelle se trouve une couche supérieure métallique structurée (2), les deux couches métalliques (2, 3) étant réfléchissantes au rayonnement laser incident (1), la structuration de la couche supérieure et la distance entre lesdites deux couches métalliques $L$ étant suffisamment petite pour que le dispositif forme une microcavité optique présentant au moins un mode de résonance; au moins une partie des puis quantiques dits puits actifs présentant une absorption intersousbande à une longueur d'onde centrale $\lambda_{ISB} = hc/E_{ISB}$, le couplage entre ladite transition intersoubsande à ladite longueur d'onde centrale $\lambda_{ISB}$ et un des modes de la microcavité entrainant l'excitation de polaritons de cavités et un dédoublement de Rabi aux énergies $E_{ISB} \pm \hbar\Omega_{Rabi}$ avec $\Omega_{Rabi}$ la fréquence de Rabi ; ledit dispositif comprenant un circuit électrique (5) configuré pour appliquer deux différences de tension distinctes, $V_0$ et $V_1$ entre les deux couches métalliques, le dispositif (4) absorbant le rayonnement incident (1) pour la différence de tension $V_0$ et le dispositif réfléchissant ou transmettant le rayonnement incident pour la différence de tension $V_1$.

Selon des modes particuliers de l'invention:

- la couche métallique inférieure ne possède pas de discontinuités et le dispositif réfléchit le rayonnement incident pour la différence de tension $V_1$ ;

- la couche supérieure métallique est formée d'une pluralité de bandes métalliques de largeur s, séparées d'une distance $a$, avec $s + a < \lambda_i/2$ ;

- la largeur des bandes métallique s est telle que $s = \lambda_i/2 . n$ à $\pm 30\%$ avec $n$ l'indice de ladite couche de semi-conducteur ;

- lequel la largeur des bandes métallique $s = \lambda_i/2 . ns$ est telle que $s = 3 . \lambda_i/2 . n$ à $\pm 30\%$ avec $n$ l'indice de ladite couche de semi-conducteur ;

- les contacts entre la couche semi-conductrice et les couches métalliques sont réalisés par des contacts Schottky ou par l'introduction de couches isolantes ;

- la distance entre lesdites deux couches métalliques $L$ est égale à $\lambda_i/30$ à $\pm 30\%$ ;

- la distance entre les deux couches métalliques L est choisie par des simulations numériques de manière à ce que ledit dispositif fonctionne en régime non dispersif ;

- les puits quantiques ou les barrières séparant les puits quantiques sont dopés électroniquement, les puits quantiques étant choisis pour que, pour une première différence de tension $V_0$ appliquée par ledit circuit électrique (5) entre lesdites deux couches métalliques, le dispositif présente une absorption aux énergies $E_{ISB} \pm \hbar\Omega_{Rabi}$ et non pas aux longueurs d'ondes égales aux modes de résonance de la cavité et pour que, pour une deuxième différence de tension $V_1$, tous les puits quantiques de la couche semi-conductrice sont dépeuplés de leurs charges, le dispositif présente une absorption aux modes de résonance de la cavité et non pas aux énergies $E_{ISB} \pm \hbar\Omega_{Rabi}$ ;

- l'épaisseur la couche semi-conductrice $L$ est telle que $V_1$ est inférieure à la tension maximale supportée par les contacts entre la couche semi-conductrice et les couches métalliques ;

- l'épaisseur $L$ de la couche semi-conductrice est choisie pour que $V_1$ soit inférieure à 10V ;

- la distance entre lesdites deux couches métalliques L est égale à $\lambda_i/10$ à $\pm 30\%$ ;

- la couche semi-conductrice comprend un empilement de puits quantiques couplés constitués d'un puits étroit non dopé dit puits actif séparé par une première barrière d'un puits large dit réservoir, les puits quantiques couplés étant séparés les uns des autres d'un autre part une deuxième barrière plus large que ladite première barrière, la première barrière ou le réservoir de chaque puits quantiques couplés étant dopé électroniquement, les puits actifs étant choisis afin qu'ils présentent une absorption intersousbande à une longueur d'onde centrale $\lambda_{ISB}$ proche d'un mode de résonance de ladite microcavité optique; lesdits puits quantiques couplés étant adaptés pour que, pour une première différence de tension $V_0$ appliquée par ledit circuit électrique (5) entre lesdites deux couches métalliques, les charges provenant du dopage sont transférés par effet tunnel dans les puits étroits et le dispositif présente une absorption aux énergies $E_{ISB} \pm \hbar\Omega_{Rabi}$ et non pas aux longueurs d'ondes égales aux modes de résonance de la cavité, et pour que, pour une deuxième différence de tension $V_1$, le dispositif présente une absorption aux longueurs d'ondes égales aux modes de résonance de la cavité et non pas aux énergies $E_{ISB} \pm \hbar\Omega_{Rabi}$ ;

- l'épaisseur $L$ de la couche semi-conductrice est choisie pour que $V_0$ soit inférieure ou égale à 2V ;

- la couche semi-conductrice est structurée pour que les empilements de puits quantiques soient situés uniquement directement en dessous des bandes métalliques de la couche métallique supérieure ;

- les puits quantiques de la couche semi-conductrice sont réalisés en GaAs/AlGaAs ; InGaAs/AllnAs ; InAs/AlSb, Si/SiGe, GaN/AlGaN ;

- la dimension caractéristique est inférieure à 200 $\mu$m ;

- la couche métallique inférieure présente des discontinuités et est structurée de manière à ce que ledit dispositif transmette le rayonnement incident pour la différence de tension $V_1$, ledit dispositif comprenant un substrat 8 transparent au rayonnement incident en dessous de la couche métallique inférieure et en contact avec cette dernière ;

**Brève description des figures** :

D'autres caractéristiques, détails et avantages de l'invention ressortiront à la lecture de la description faite en référence aux dessins annexés donnés à titre d'exemple et qui représentent, respectivement :

[Figure 1], une vue schématique d'un dispositif de modulation ultra-rapide de l'amplitude d'un rayonnement laser incident selon un premier mode de réalisation de l'invention ;

[Figure 2], un diagramme de bande du dispositif en régime non dispersif ;

[Figure 3], un diagramme de bande du dispositif en régime dispersif ;

[Figure 4], une vue schématique d'un dispositif de modulation ultra-rapide de l'amplitude d'un rayonnement laser incident selon un deuxième mode de réalisation de l'invention ;

[Figure 5], la réflectivité des dispositifs de l'invention avec ou sans tension appliquée;

[Figure 6], une vue schématique d'un dispositif de modulation ultra-rapide de l'amplitude d'un rayonnement laser incident en transmission selon un troisième mode de réalisation de l'invention ;

[Figure 7], la couche métallique supérieure d'un dispositif de modulation selon un mode de réalisation de l'invention ;

[Figure 8], une illustration d'un dispositif de modulation selon un mode de réalisation de l'invention ;

[Figure 9], une illustration d'un dispositif de modulation selon un mode de réalisation de l'invention.

**Description détaillée :**

L'invention a pour objet, entre autre, un dispositif constitué d'une couche semi-conductrice insérée dans une microcavité permettant de moduler l'amplitude d'un rayonnement laser incident en appliquant un champ électrique externe dans la cavité. Le couplage lumière-matière entre la microcavité et la couche semi-conductrice est réalisé en régime de couplage fort.

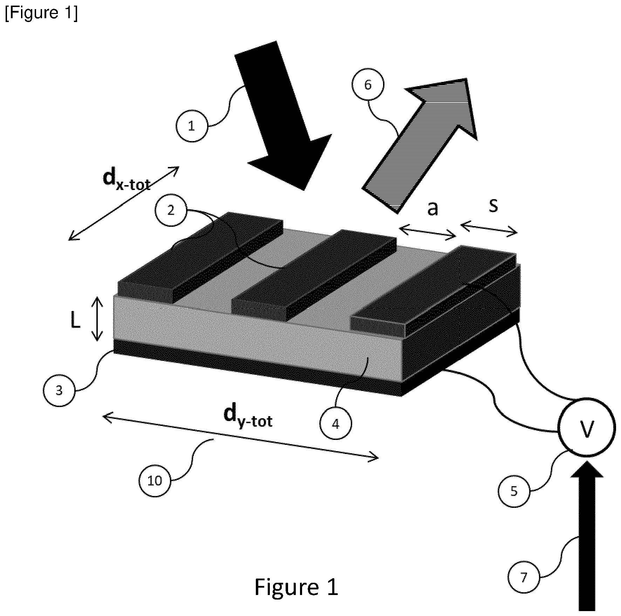

La figure 1 est un schéma d'un dispositif 10 de modulation ultra-rapide de l'amplitude d'un rayonnement laser incident 1 selon un premier mode de réalisation de l'invention. Ce dispositif 10 fonctionne en réflexion et permet d'obtenir une modulation rapide (supérieure à 10MHz) avec une profondeur de modulation dépassant 90%. Dans le mode de réalisation de la figure 1, le rayonnement laser incident 1 dont on souhaite moduler l'amplitude est de longueur d'onde $\lambda_i$ avec $\lambda_i \in$ [3 - 20 µm] donnant ainsi un rayonnement laser modulé 6.

Dans le mode de réalisation de la figure 1, le rayonnement laser 1 est à onde continue. Alternativement, le rayonnement laser 1 peut être un rayonnement impulsionnel.

Le dispositif 10 de la figure 1 est constitué d'une première couche inférieure métallique 3, d'une couche intermédiaire semi-conductrice 4 et d'une couche supérieure métallique 2. Les deux couches métalliques font entre 80 et 300nm d'épaisseur. La couche intermédiaire semi-conductrice est aussi appelée région active.

La couche inférieure métallique est uniforme et ne possède pas de discontinuités. La couche supérieure métallique est formée d'une pluralité de bandes métalliques de largeurs, séparées d'une distance $a$, avec s + a < $\lambda_i$/2. Ce critère est important car il permet d'éviter que le dispositif se comporte comme un réseau de diffraction et empêche donc l'apparition d'ordres de diffractions supplémentaires lors de la modulation d'un rayonnement laser incident.

Dans le mode de réalisation de la figure 1, la distance entre les deux couches métalliques ou l'épaisseur maximale de la région active $L$ est largement inférieure à la longueur d'onde du rayonnement laser incident (L<= λ/10). Ainsi la cavité formée par les deux couches métalliques se comporte comme une microcavité ou un micro-résonateur optique avec un seul mode de résonance à la longueur d'onde $\lambda$. Dans la suite on considère que l'épaisseur de la région active et la distance entre les deux couches métalliques sont égales et valent L.

Le dispositif de la figure 1 comprend un circuit électrique 5 configuré pour appliquer, à partir d'un signal RF incident 7, une différence de tension entre les deux couches métalliques. Les contacts entre la couche intermédiaire semi-conductrice et les couches métalliques sont réalisés par des contacts Schottky en déposant directement le contact métallique (ex. Titanium/Or) sur la couche semi-conductrice, ou bien par l'introduction de couches isolantes comme du SiN ou du SiO2 ou tout autre isolant compatible avec la fabrication de dispositifs optoélectroniques afin d'éviter qu'un courant trop important traverse la couche semi-conductrice. On détaillera plus loin l'effet de l'application ou non d'une différence de tension (et donc la création d'un champ électrique) entre les deux couches métalliques. On mentionnera simplement ici qu'il permet d'induire un changement de l'absorption de la couche semi-conductrice à une longueur d'onde donnée.

Selon l'épaisseur L de la couche semi-conductrice, la microcavité peut fonctionner en modalité non dispersive ou dispersive. En mode dispersif, la ou les fréquences de résonance de la microcavité dépendent de l'angle du rayonnement incident alors qu'en mode non dispersif, la ou les fréquences de résonance ne dépendent pas de l'angle d'incidence du rayonnement incident. Dans ce dernier cas les fréquences de résonance sont fixées simplement par la largeur des bandes métalliques s. Il faut noter que L n'affecte pas la longueur d'onde de fonctionnement du dispositif, mais seulement le régime de fonctionnement dispersif ou non-dispersif.

Dans le premier mode de réalisation, l'épaisseur L de la couche semi-conductrice est environ égale à $\lambda_i$/30 afin de fonctionner en mode non dispersif, avec $\lambda_i$ la longueur d'onde du rayonnement laser incident dont on souhaite moduler l'amplitude. Ainsi, chaque bande métallique appartenant à la couche métallique supérieure forme avec la couche métallique inférieure une cavité « unitaire », et le champ électromagnétique étant localisé dans chaque cavité unitaire, uniquement en dessous de chaque bande métallique. Il n'existe donc pas d'interaction entre les cavités unitaires à cause du fort confinement latéral de la résonance. Dans ce cas, la réflectivité du dispositif est très élevée. De manière générale on considère que le micro-résonateur fonctionne en régime non dispersif si l'épaisseur de la région active est égale à $\lambda_i$/30 à ± 30%. De préférence, l'épaisseur de la région active L est choisie par des simulations numériques de la structure de bande du résonateur de manière à fonctionner en régime non dispersif.

Dans ce mode de réalisation non-dispersif, la largeur des bandes s permet de fixer la longueur d'onde d'utilisation du dispositif 10 de modulation de l'amplitude. Lorsque la couche semi-conductrice n'absorbe pas le rayonnement laser incident, le dispositif 10 peut fonctionner sur deux modes de résonance $TM_{00}$ et $TM_{02}$ qui correspondent à deux longueurs d'ondes différentes : $\lambda$ = 2. $n.s$ et $\lambda$ = 2.$n.s$/3 respectivement, avec $n$ l'indice de réfraction de la couche semi-conductrice. Alternativement, selon un autre mode de réalisation, le dispositif 10 fonctionne sur les modes de résonnance $TM_{0i}$ avec

$i \in \mathbb{N}$ , chaque mode correspondant à la longueur d'onde $\lambda_i$ = 2.$n.s$/($i$ + 1).

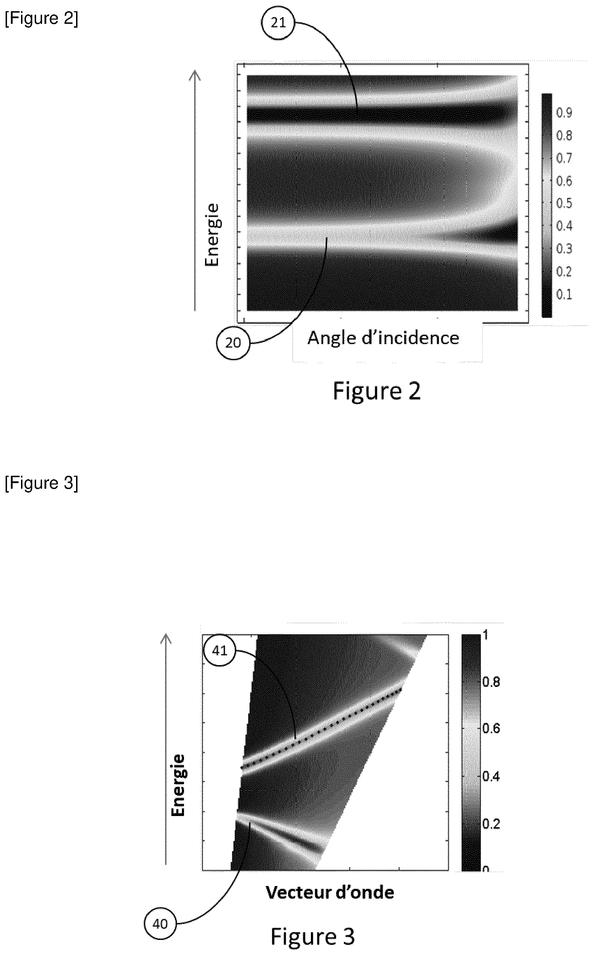

La figure 2 illustre schématiquement les modes de résonnance dans le cas de fonctionnement non dispersif. Elle représente la réflectivité du dispositif de la figure 1 en fonction de la fréquence et de l'angle du rayonnement laser incident (lorsque la couche intermédiaire semi-conductrice n'absorbe par le rayonnement laser incident). Les deux bandes horizontales 20 et 21 correspondent aux deux modes de résonance $TM_{00}$ et $TM_{02}$ respectivement. Chaque mode de résonnance possède une certaine largeur de raie δE. Comme mentionné précédemment, de par la faible distance entre les deux couches métalliques, la fréquence des modes de résonnance de la cavité est indépendante de l'angle d'incidence du rayonnement laser. Par exemple, dans le mode de réalisation de la figure 1, on peut utiliser le mode de résonance $TM_{00}$, à la longueur d'onde $\lambda_{cav}$ = h. c/$E_{cav}$ = 9.5$\mu m$ . La couche semi-conductrice est composée d'empilement de puits quantiques en GaAs, possédant un indice de réfraction $n \approx 3.3$. La largeur des bandes métalliques vaut alors s = 1.44$\mu m$. La largeur de raie du mode de résonance vaut $\delta E_{cav}$.

Après avoir fixé la longueur d'onde d'utilisation en fixant la largeur des bandes métalliques $s$, la séparation $a$

entre les bandes métalliques est choisie par simulation de manière à se placer le plus proche possible du couplage critique optique. Dans cette condition, les pertes du résonateur (donnant la largeur de raie des modes de résonances) sont égales au taux de couplage des photons provenant du rayonnement incident, ce qui implique que toute l'énergie du rayonnement incident est absorbée. En effet, a fixe la densité de bandes métalliques. Concrètement, on optimise a avec s fixé de manière à obtenir le meilleur contraste en réflectivité en fonction de la longueur d'onde du rayonnement incident. L'optimisation de l'espacement a est effectuée par simulation, la valeur optimale pouvant varier selon la région active semiconductrice. Dans le mode de réalisation de la figure 1, on a $a$=1.1$\mu$m.

Alternativement, le dispositif 10 peut fonctionner en régime dispersif. Dans ce régime de fonctionnement, l'épaisseur de la couche semi-conductrice $L$ est choisie environ égale à $\lambda_i$/10. En effet, pour une telle épaisseur, le champ électromagnétique n'est plus localisé uniquement en dessous des bandes métalliques de la couche supérieure dans les cavités unitaires qui se couplent donnant lieu au comportement dispersif. On considère que le micro-résonateur fonctionne en régime dispersif si l'épaisseur L de la région active est supérieure ou égale à $\lambda_i$/10. Dans ce régime de fonctionnement, la fréquence des modes optiques dépend de l'angle d'incidence.

La figure 3 illustre les deux modes optiques de résonnance du dispositif 10 lorsqu'il fonctionne en régime dispersif, c'est-à-dire lorsque l'épaisseur L de la région active est supérieure à $\lambda_i$/10. La figure 3, tout comme la figure 2 représente la réflectivité du dispositif 10 en fonction de la fréquence du rayonnement incident lorsque la couche intermédiaire semi-conductrice n'absorbe pas le rayonnement laser incident. Comme expliqué précédemment, on observe une dépendance de la fréquence des deux modes de résonnance 40 et 41 en fonction de la longueur d'onde. La distance entre les deux branches est fixée par le rapport $s/a$. De manière concrète, le dispositif 10 en régime dispersif du mode de réalisation de la figure 3 possède une fréquence optimale de fonctionnement accordable en fonction de l'angle d'incidence. Cependant, dans la suite, on considère que l'épaisseur de la région active est telle que le dispositif 10 de la figure 1 fonctionne en régime non dispersif.

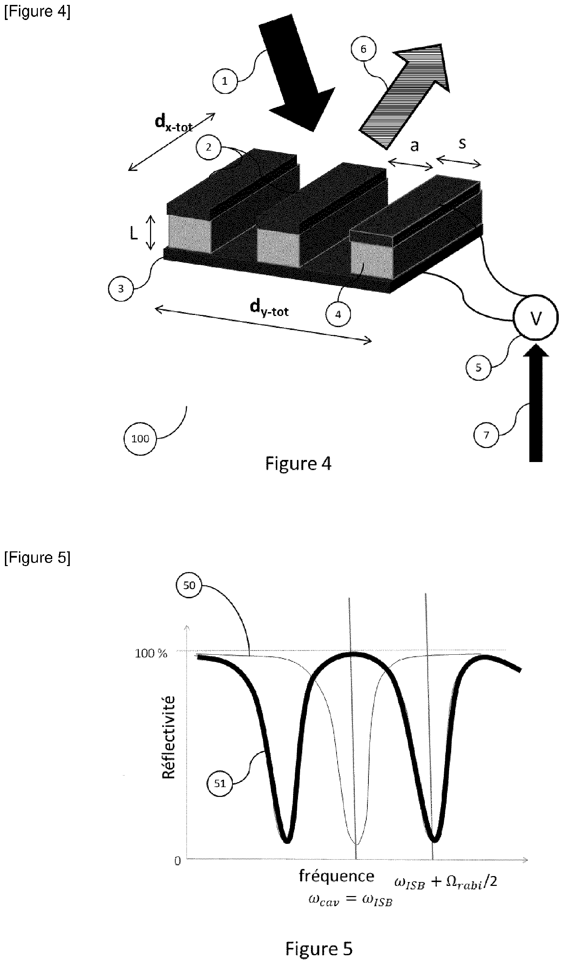

Dans un autre mode de réalisation, illustré en figure 4, le dispositif 100 possède une couche semi-conductrice 4 uniquement comprise en dessous des bandes métalliques (dans les cavités unitaires). Il n'y a pas de couche semi-conductrice entre les cavités unitaires (entre les bandes métalliques de la couche métallique supérieure). Autrement dit, la région active est gravée dans les portions de la région active non recouvertes par le métal. Ceci permet de créer une interface air/semi-conducteur entre les cavités unitaires et donc d'obtenir un meilleur confinement des modes électromagnétiques dans les cavités unitaires. On obtient ainsi un meilleur couplage du rayonnement laser incident dans la cavité. Dans ce mode de réalisation l'épaisseur de la région active L est choisie de manière à fonctionner en régime non-dispersif. L'épaisseur de la couche semi-conductrice est donc environ égale à $\lambda_i$/30. Il faut noter que, dans le mode de réalisation de la figure 4 il est en pratique difficile d'obtenir un régime de fonctionnement dispersif.

Dans le mode de réalisation de la figure 1, la couche semi-conductrice est composée de 7 puits quantiques identiques en GaAs de $L_{QW}$ = 9.5$nm$ de largeur et des barrières en Al$_{0.3}$Ga$_{0.7}$As de 20 nm de largeur. Les puits quantiques possèdent un dopage électronique (de type n) de $6.10^{11}$ $cm^2$, qui est introduit sous forme de delta-doping dans les barrières de Al$_{0.3}$Ga$_{0.7}$As. Alternativement, le dopage peut être introduit dans les puits. Les puits quantiques possèdent

$$\lambda_{ISB} = h.\frac{c}{E_{ISB}} = 9.5\mu m$$

alors une absorption intersousbande (ISB) à ⟨⟩ avec une largeur de raie $\frac{\Delta\omega}{\omega} \sim 10\%$, le niveau d'absorption étant proportionnel au dopage introduit dans les puits quantiques. Cette raie d'absorption est en résonance avec le mode TM$_{00}$ de la microcavité donnant lieu à un couplage fort lumière matière qu'on détaillera plus bas. Dans un autre mode de réalisation, la structure, le dopage et le matériau des puits quantiques et des barrières sont choisis de manière à ce que les puits quantiques présentent une transition intersousbande d'énergie $E_{ISB}$ = h. c/$\lambda_{ISB}$ de largeur de raie $\delta E_{ISB}$ proche d'un mode de résonance de la microcavité d'énergie $E_{cav}$ de largeur de raie $\delta E_{cav}$. Par proche, on entend que $|E_{ISB} - E_{cav}| < \delta E_{cav} + \delta E_{ISB}$.

Dans un deuxième mode de réalisation, illustré dans la figure 4 le dispositif 100 comprend une couche semi-conductrice constituée d'un empilement d'une pluralité de paires de puits quantiques couplés. Dans ce mode de réalisation, les puits quantiques couplés sont formés par un puits étroit non dopé dit puits actif et un puits large dopé électroniquement dit réservoir, séparés par une première fine barrière. Chaque paire de puits quantiques couplés est séparée par une deuxième barrière plus large que la première. Alternativement, le dopage électronique peut être introduit dans la première fine barrière séparant le puits large du puits actif.

Par exemple, la couche semi-conductrice peut être constituée de 5 empilements de la structure suivante : un puits actif en GaAs de largeur $L_{QW}$ = 7.5$nm$ séparé par une mince barrière en Al$_{0.3}$Ga$_{0.7}$As de 4$nm$ d'un puits large de GaAS de 14.5$nm$ avec un dopage de $6.10^{11}$ $cm^{-2}$ ou bien $1.2.10^{12}$ $cm^{-2}$. Les puits couplés étant séparés entre eux par une barrière de 18$nm$ d'Al$_{0.3}$Ga$_{0.7}$As.

Dans ce mode de réalisation les puits actifs présentent une transition ISB à $\lambda_{ISB}$=9.5$\mu$m de largeur de raie $\delta E_{ISB}$. Cependant, les charges provenant du dopage étant dans les puits réservoirs et non pas dans les puits actifs, en l'état, la couche semi-conductrice du dispositif 100 n'absorbe pas à 9.5$\mu$m.

Alternativement, la structure de la région active du mode de réalisation de la figure 4 peut être identique à celle utilisée dans le dispositif 10 de la figure 1 et la structure de la région active du mode de réalisation de la figure 1 peut être identique à celle utilisée dans le dispositif 100 de la figure 4.

Comme mentionné précédemment, la mise en microcavité résonnante des puits quantiques modifie les interactions entre le photon et l'excitation intersousbande, que nous appelons plasmon ISB. En effet, la microcavité semi-conductrice permet de coupler de manière sélective un unique mode du champ électromagnétique de la cavité à un unique mode plasmon ISB. Dans le mode de réalisation de la figure 1 c'est le mode $TM_{00}$ qui est couplé à la transition ISB à $9.5\mu m$. L'élément de la matrice de ce couplage lumière-matière est exprimé par la quantité $\Omega_{rabi}$, appelée fréquence de Rabi. Plus cette quantité $\Omega_{rabi}$ est élevée, plus le couplage est fort.

On définit :

$$[Math.1] \qquad E_{rabi} = \hbar\Omega_{rabi} = L_{QW,tot}/2L \times \sqrt{\frac{f_{12}.n_d.e^2}{\epsilon_0.\epsilon_{slab}\, m^*.L_{QW}}}$$

Avec $L_{QW,tot}$ la longueur totale des puits des seuls puits quantiques actifs dans la structure, $L$ la longueur totale de la couche semi-conductrice, $L_{QW}$ la longueur des puits quantiques actifs, $f_{12}$ la force d'oscillateur de la transition ISB des puits quantiques actifs (déterminée par calcul numérique), $\varepsilon_0$ est la constante diélectrique du vide, $\varepsilon_{slab}$ est la constante diélectrique de la région active et $m^*$ est la masse effective de l'électron dans les puits quantiques actifs. Enfin, $n_d$ est le dopage surfacique électronique introduit dans chaque puits quantique, ou barrière dans le cas du *delta doping.*

Dans le mode de réalisation de la figure 1, $n_d$ correspond au dopage introduit dans les barrières de $Al_{0.3}Ga_{0.7}As$, et dans le deuxième mode de réalisation (Figure 4) $n_d$ correspond au dopage introduit dans les puits réservoirs ou dans les barrières. Dans ce mode de réalisation, $L_{QW,tot} = L$.

Afin d'obtenir un contraste de modulation le plus élevé possible entre l'état absorbant et non absorbant du dispositif, celui-ci fonctionne en régime de couplage fort photon - plasmon ISB. En effet, sous certaines conditions, ce couplage peut devenir un couplage dit fort, et de nouveaux modes propres du système apparaissent alors, appelés polaritons de cavité. On définit $\delta E_{cav}$ et $\delta E_{ISB}$ les largeurs de raies du mode de résonance de la cavité et de la transition ISB couplés.

Lorsque $E_{rabi}$ « $\delta E_{cav}$, $\delta E_{ISB}$, l'émission spontanée est irréversible, le photon *émis lors de la* recombinaison radiative « se perd » dans la cavité, la force de l'oscillateur (du couplage) liée à $\Omega_{rabi}$ est trop faible pour permettre de nouveau l'absorption de ce photon. C'est le régime de *couplage faible.* A l'inverse, lorsque $E_{rabi}$ » $\delta E_{cav}$, $\delta E_{ISB}$, *le photon émis* reste *dans la cavité* suffisamment longtemps pour être réabsorbé : c'est le régime de *couplage fort.* Il y a donc échange cohérent d'énergie entre *le* puits quantique et le mode photonique de cavité: le phénomène est réversible. Ce sont les oscillations de Rabi. Dans ce régime, les états propres du système sont les états mixtes photon-plasmon ISB appelés polaritons (*upper polaritons* et *lower polaritons*). Dans le domaine spectral, les oscillations de Rabi sont révélées par une séparation en énergie 2. $\Omega_{rabi}$, appelée *splitting* ou dédoublement de Rabi, et par l'anti-croisement observé entre les états couplés. Concrètement, ce couplage fort et ce dédoublement de Rabi se traduit par un dédoublement aux fréquences $\pm\Omega_{rabi}$ de la simple transition intersousbande -isolée de tout couplage- à $\omega_{ISB} = 2\pi c/\lambda_{ISB}$. A l'inverse, un régime de couplage faible entre une transition ISB et un mode de résonance de cavité se traduit uniquement par un élargissement de la résonance de la cavité.

Dans tous les modes de réalisation de l'invention, on paramètre les puits quantiques et la microcavité de manière à avoir $\delta E_{cav}, \delta E_{ISB} \approx E_{ISB}/10$.

Les différents paramètres de la structure de la couche semi-conductrice influant le dédoublement de Rabi ($L_{QW,tot}$, $L$, $L_{QW}$, $f_{12}$, $\varepsilon_{slab}$, $n_d$) sont donc choisis de manière appropriée pour que $E_{Rabi} > \delta E_{ISB}$, $\delta E_{cav}$. Avec $\delta E_{ISB}, \delta E_{cav} < E_{ISB}/10$, on souhaite donc $E_{rabi}$ » $E_{ISB}/10$ (voir [Math.1]).

On comprend alors que, sans champ électrique généré entre les couches métalliques grâce au circuit électrique 5, le dispositif 10 de la figure 1 absorbe un rayonnement laser incident aux fréquences $\omega_{ISB} \pm \pm\Omega_{rabi}$ et n'absorbe pas à la fréquence $\omega_{ISB}$ correspondant à la transition ISB des puits quantiques, proche d'un mode de résonance de la cavité de fréquence $\omega_{cav}$. En effet, les électrons sont présents dans les puits quantiques dans la cavité et le couplage fort donne lieu à la formation des polaritons de cavités et au dédoublement de Rabi.

De même, sans champ électrique généré entre les couches métalliques, seul un rayonnement laser à une fréquence égale à un mode de résonance de la cavité $\omega_{cav}$ est absorbé par le dispositif 100 de la figure 4. En effet, les électrons provenant du dopage sont présent dans les puits réservoirs et non dans les puits quantiques actifs présentant une transition ISB à la fréquence $\omega_{ISB}$ proche d'un mode de résonance de la cavité $\omega_{cav}$. La couche semi-conductrice est donc transparente à un rayonnement laser incident à la fréquence $\omega_{cav}$, cependant la cavité permet un couplage (donc une absorption) d'un rayonnement laser incident à une telle fréquence. A l'inverse, un rayonnement incident possédant une fréquence différente d'un mode de résonance de la microcavité sera réfléchit par le dispositif 100.

Le circuit électrique 5 est adapté pour appliquer une différence de tension entre les deux couches métalliques.

Dans le mode de réalisation de la figure 1 et de la figure 4, le circuit électrique est configuré pour appliquer une différence de tension entre les deux couches métalliques $V_1 = F * L$, avec $F$ le champ électrique nécessaire pour « vider » ou dépeupler les puits quantiques des charges provenant du dopage. En effet, l'application d'un biais électrique permet un déplacement rapide des charges depuis les puits quantiques vers une des couches métalliques.

Dans le mode de réalisation de la figure 1, avec la structure exemple en GaAs présentée précédemment, $V_1 = 6V$. L'application d'une telle différence de tension va donc permettre de rendre la couche semi-conductrice transparente à un rayonnement laser incident de energie $E_{ISB} \pm \hbar\Omega_{Rabi}$ $\lambda_{ISB} \pm \hbar\Omega_{rabi}$ : les électrons n'étant plus présents dans les puits quantiques, un photon à un mode de résonance de la cavité ne se couple plus en régime fort, de manière sélective, à une transition ISB des puits quantiques de la couche semi-conductrice, créant des polaritons de la cavité.

Ainsi, lors de l'application d'une différence de tension $V_1 = F * L$ entre les deux couches métalliques, le dispositif se comporte comme une microcavité « classique » : le dispositif de la figure 1 réfléchit un rayonnement laser à une energie $E_{ISB} \pm \hbar\Omega_{Rabi}$. $\lambda_{ISB} \pm h\Omega_{rabi}$ En effet, ces longueurs d'ondes ne correspondant pas à des modes de résonance de la cavité, le rayonnement laser ne sera pas couplé (donc pas absorbé) par la cavité. A l'inverse, le dispositif de la figure 1 absorbe tout rayonnement laser incident avec une longueur d'onde correspondant aux modes de résonance de la cavité.

En prenant comme référence un rayonnement laser incident à une longueur d'onde $\lambda_i$ égale à un mode de résonance de la cavité, on appellera l'état « absorbant » l'état du dispositif 10 correspondant à une différence de tension $V_1 = F * L$ appliquée entre les deux couches métalliques et l'état « réfléchissant » l'état correspondant à une différence de tension nulle ($V_0 = 0V$) entre les deux couches métalliques.

L'utilisation du régime de couplage fort et du dédoublement de Rabi permet donc au dispositif de la figure 1 d'obtenir une très bonne profondeur de modulation (>90%) entre l'état absorbant et l'état réfléchissant.

La figure 5 illustre schématiquement la réflectivité du dispositif 10 en fonction de la fréquence du rayonnement laser incident et en fonction de la différence de tension appliquée entre les couches métalliques. La courbe 50 (trait fin) représente la réflectivité du dispositif pour l'état absorbant (une différence de tension $V_1 = F * L$ entre les deux couches métalliques). Comme mentionné précédemment, dans ce cas de figure, les charges ne sont plus dans les puits quantiques, il n'existe donc pas de dédoublement de Rabi et le dispositif se comporte comme une microcavité « classique » : c'est-à-dire qu'il absorbe un rayonnement laser incident si sa longueur d'onde est égale à un mode de résonance de la cavité.

La courbe 51 (trait épais) représente la réflectivité du dispositif pour l'état réfléchissant (une différence de tension nulle entre les deux couches métalliques). Dans ce cas de figure, le dopage est présent dans les puits quantiques dans la cavité, ce qui donne lieu à la formation des polaritons de cavités et au dédoublement de Rabi aux fréquences $\omega_{ISB} \pm \Omega_R$ à partir de la simple transition ISB à $\omega_{ISB}$ proche d'un mode de résonance de la cavité à $\omega_{cav}$. Ce dédoublement provoque une absorption du dispositif 10 d'un rayonnement laser incident aux energies $E_{ISB} \pm \hbar\Omega_{Rabi}$ $\lambda_{ISB} \pm \hbar\Omega_R$ et une réflexion d'un rayonnement laser incident à la longueur d'onde $\lambda_{ISB}$.

Il est important de noter que, dans le mode de réalisation de la figure 1, la distance entre les deux couches métalliques $L$ (donc ici l'épaisseur maximale de la couche semi-conductrice) n'est pas uniquement limitée par le souhait de fonctionner en régime non dispersif de cavité. L'épaisseur de la couche semi-conductrice est aussi limitée par la tension de grille maximale $V_{max}$ que les contacts Schottky entre la couche semi-conductrice et les couches métalliques peuvent supporter. Cela implique $V_1 = F * L < V_{max} = F * L_{max}$, ce qui impose une borne supérieure $L_{max}$ sur l'épaisseur de la couche semi-conductrice telle que $L < L_{max}$. En utilisant des contacts Ti/Au sur du GaAs non dopé, il est possible d'obtenir un $V_{max}$ de l'ordre de $\pm 5V$. On peut dépasser cette valeur en utilisant des couches isolantes (SiN, SiO2, Al2O3, ...).

Le déplacement des charges provoqué par l'application d'une différence de tension est un phénomène rapide, cependant limité par le temps de déplacement sur des dizaines voire des centaines de nanomètres des électrons depuis les puits quantiques vers une des couches métalliques. Aussi, dans le mode de réalisation de la figure 1, la fréquence de réponse du dispositif 10 reste inférieure au GHz. Afin d'améliorer le temps de réponse de ce mode de réalisation, il est possible de réduire l'épaisseur de la couche semi-conductrice.

Cette limitation intrinsèque du temps de réponse du dispositif 10 du mode de réalisation de la figure 1 n'est pas présente dans le mode réalisation de la figure 4. En effet, dans le dispositif 100, le circuit électrique 5 est configuré pour appliquer une différence de tension choisie pour créer un biais ou champ électrique permettant de réaliser un transfert par effet tunnel des électrons introduits lors du dopage dans les puits réservoirs vers les puis actifs. Ce transfert de charge implique que le dopage électronique est présent dans les puits quantiques actifs dans la cavité, ce qui donne lieu à la formation des polaritons de cavités et au dédoublement de Rabi, la structure fonctionnant alors en couplage fort. Ainsi, pour une différence de tension $V_1 \neq 0$ choisie de manière appropriée, le dispositif 100 de la figure 4 absorbe un rayonnement laser incident aux fréquences $\omega_{ISB} \pm \pm\Omega_R$ et n'absorbe pas à la fréquence $\omega_{ISB}$ correspondant à la transition ISB des puits quantiques actifs, proche d'un mode de résonance de la cavité de fréquence $\omega_{cav}$. En utilisant la même référence que celle du dispositif 10, on dira qu'il est dans un état réfléchissant pour une différence de tension entre les deux couches métalliques $V_1 \neq 0$ et dans un état absorbant pour $V_0 = 0V$.

La figure 5 permet aussi d'illustrer schématiquement la réflectivité du dispositif 100 en fonction de la fréquence du rayonnement laser incident et en fonction de la différence de tension appliquée entre les couches métalliques. La courbe 50 représente la réflectivité du dispositif pour l'état absorbant (une différence de tension nulle entre les deux couches métalliques). Comme mentionné précédemment, dans ce cas de figure, les électrons sont dans les réservoirs, il n'existe donc pas de dédoublement de Rabi et le dispositif se comporte comme une microcavité « classique » : c'est-à-dire qu'il absorbe un rayonnement laser incident si sa longueur d'onde est égale à un mode de résonance de la cavité.

La courbe 51 représente la réflectivité du dispositif pour l'état réfléchissant (une différence de tension $V_1 \neq 0$ entre les deux couches métalliques). Dans ce cas de figure, le dopage est transféré depuis les réservoirs vers les puits actifs, dans la cavité, ce qui donne lieu à la formation des polaritons de cavités et au dédoublement de Rabi aux fréquences $\omega_{ISB} \pm \pm\Omega_R$ à partir de la simple transition ISB des puits actifs à $\omega_{ISB}$ proche d'un mode de résonance de la cavité à $\omega_{cav}$. Ce dédoublement provoque une absorption du dispositif 100 d'un rayonnement laser incident aux énergies $E_{ISB} \pm \hbar\Omega_{Rabi}$ et une réflexion d'un rayonnement laser incident à la longueur d'onde $\lambda_{ISB}$.

Tout comme avec la région active de la figure 1, dans le dispositif de la figure 3, L'utilisation du régime de couplage fort et du dédoublement de Rabi permet d'obtenir une très bonne profondeur de modulation (>90%) entre l'état absorbant et l'état réfléchissant.

La barrière entre les puits actifs et les réservoirs étant très mince (quelques nanomètres), le transfert par effet tunnel est très rapide (de l'ordre de la picoseconde). Aussi, la fréquence de réponse du dispositif de la figure 3 est très élevée (supérieure au GHz) et uniquement limitée par la constante RC du circuit électrique.

Un autre avantage du mode de réalisation de la figure 3 est que la différence de tension nécessaire pour provoquer le transfert de charges des réservoirs aux puits actifs et donc passer de l'état absorbant à l'état réfléchissant est plus faible que pour le mode de réalisation de la figure 1. Ainsi, dans le dispositif 100, une tension $V_1 = 2V$ est suffisante à $\lambda=9\ \mu m$ pour provoquer le transfert de charge vers les puits actifs. Cette valeur est bien inférieure à celle nécessaire pour vider les puits quantiques du mode de réalisation de la figure 1 (où $V_1 = 6V$) et permet de s'assurer que l'on a bien $V_1 < V_{max}$.

Par ailleurs, dans les modes de réalisation de la figure 1 ou 4, la largeur totale $d_{x-tot}$ et la longueur totale $d_{y-tot}$ du dispositif 100 sont de préférence largement inférieures à 200 $\mu m$. Cela permet de réduire la constante RC du dispositif. On appelle dimension caractéristique la plus grande distance entre largeur totale $d_{x-tot}$ et longueur totale $d_{y-tot}$.

De même, dans tous les modes de réalisations, les contacts et microsoudures sont adaptés de manière à ne pas limiter le temps de réponse du dispositif.

Dans un autre mode de réalisation, le dispositif peut être refroidi jusqu'à 78K à l'aide d'un cryostat ou bien avec un Peltier par exemple. Ce refroidissement est particulièrement nécessaire si l'on souhaite moduler des ondes THz. On définit THz comme $\lambda > 30\ \mu m$.

Dans un autre mode de réalisation, dans le cas de fonctionnement en régime non-dispersif, on choisit $s = 3.\lambda_l/2.n$, avec $\lambda_l$ la longueur d'onde du rayonnement laser incident dont on souhaite moduler l'amplitude. Ainsi, on utilise le mode de résonance $TM_{02}$ de la cavité afin d'augmenter le facteur de superposition entre le mode électromagnétique et la région active semi-conductrice et ainsi augmenter le dédoublement de Rabi de la transition ISB des puits quantiques actifs de fréquence proche du celle du mode $TM_{02}$. Cela permet une meilleure séparation en fréquence entre la raie d'absorption correspondant au mode de cavité $TM_{03}$ dans l'état absorbant et les deux raies correspondant au dédoublement de Rabi de ladite transition ISB des puits quantiques actifs. On obtient ainsi une meilleure profondeur de modulation. De plus, la fabrication du résonateur est aussi simplifiée grâce aux dimensions plus importantes des bandes métalliques.

Dans un autre mode de réalisation, les puits quantiques sont réalisés en GaAs/AlGaAs ; InGaAs/AlInAs ; InAs/AlSb, Si/SiGe, GaN/AlGaN ou tout autre matériau permettant de réaliser des puits quantiques avec une transition ISB comprise entre 3 $\mu m$ et 200 $\mu m$.

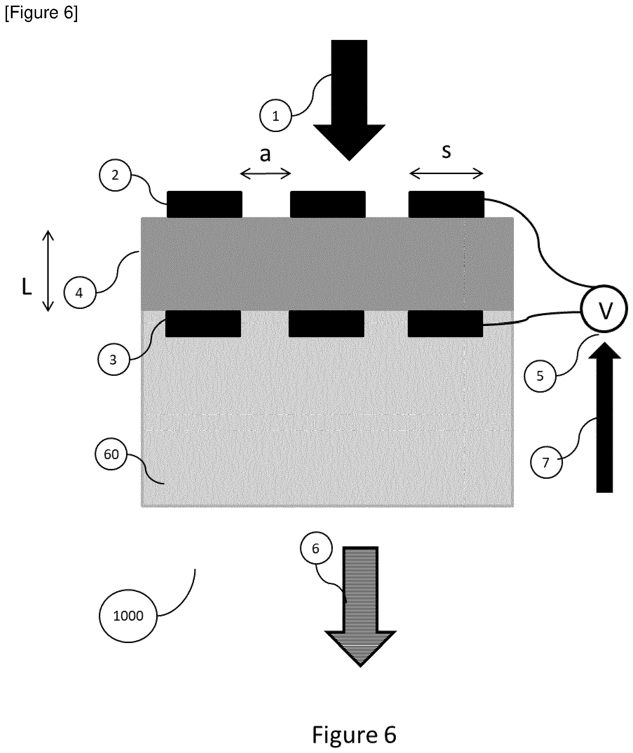

La figure 6 présente une autre mode de réalisation d'un dispositif 1000 de modulation de l'amplitude d'un rayonnement laser incident. A l'inverse des autres modes de réalisation de l'invention, ce dispositif fonctionne en transmission. Pour cela, la couche inférieure métallique 3 possède des discontinuités et est structurée de la même manière que la couche supérieure métallique 2 de sorte que les bandes métalliques des couches métalliques supérieure et inférieure soient en vis-à-vis. Ainsi l'ensemble formé par les deux couches métalliques et la couche intermédiaire semi-conductrice constitue un micro-résonateur qui transmet un rayonnement incident à une longueur d'onde $\lambda_i$ lorsque la couche semi-conductrice 3 n'absorbe pas pour cette longueur d'onde et lorsque $\lambda_i$ ne correspond pas à un mode de résonance de la cavité. A l'inverse, lorsque le rayonnement incident possède une longueur d'onde $\lambda_i$ qui correspond à un mode de résonance de la microcavité et que la région active n'absorbe pas à cette longueur d'onde, le rayonnement incident est couplé (et donc absorbé) par la cavité. L'épaisseur L de la région active 3 peut être choisie de manière à fonctionner en régime dispersif ou non dispersif. Le dispositif comprend un substrat 8 en dessous de la couche métallique inférieure et en contact avec cette dernière qui est un composant transparent au rayonnement laser incident. Ce substrat peut être en $CaF_2$, ZnSe, $BaF_2$ ou tout autre matériau transparent au rayonnement IR-moyen. Les matériaux à base de fluor ($CaF_2$, $BaF_2$) sont particulièrement adapté car ils ont un indice de réfraction faible (n<1.5) dans la gamme spectrale du moyen-IR. Dans un mode de réalisation le substrat 8 est collé à ladite couche métallique inférieure 3. Le principe de fonctionnement reste identique aux autres modes de réalisation, c'est-à-dire que grâce à l'application d'une différence de tension entre les deux couches métalliques à l'aide d'un circuit électrique 5, on passe d'un « état absorbant » à un « état transmission » (ou l'inverse selon la structure de la région active) en provoquant un déplacement des charges introduites par dopage dans la région active.

Alternativement, dans le dispositif 1000, la couche semi-conductrice 4 peut être uniquement comprise en dessous des bandes métalliques, il n'y a alors pas de couche semi-conductrice dans les portions de la région active non recouvertes par le métal. Il est possible de retirer les portions de couche semi-conductrice souhaitée à l'aide d'une étape de gravure par exemple. Il faut noter que dans ce mode de réalisation il est pratique difficile de fonctionner en mode dispersif.

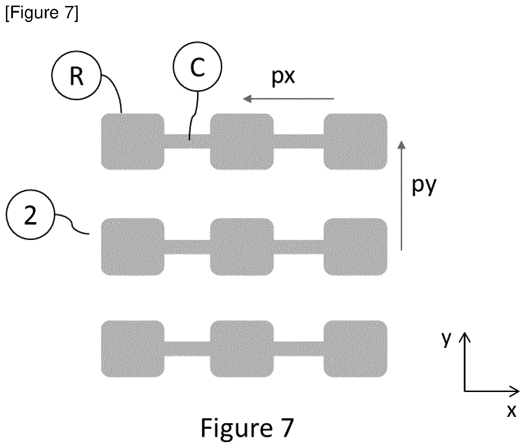

Dans un autre mode de réalisation illustré en figure 7, la couche supérieure métallique 2 est structurée dans les deux directions x et y de manière à former des résonateurs 2D (ou cavités) R pouvant être connectés électriquement. Dans ce mode de réalisation, le dispositif fonctionne en régime non dispersif (L<$\lambda$/30). La structuration de la couche est adaptée de manière à former, avec la couche métallique 3 et la couche semi-conductrice 4, des résonateurs de forme carrée, rectangulaire, triangulaire, autre... tous identiques et supportant des modes résonants à la longueur d'onde $\lambda_i$. De manière connue, la longueur d'onde de résonance de ces résonateurs dépend de la structuration de la couche 2 et plus précisément de la forme et de la dimension des cavités. Ces modes de résonances peuvent être déterminés numériquement ou - pour les géométries simples - analytiquement. L'espacement px et py selon les directions x et y entre les résonateurs est préférentiellement choisi de manière à se placer le plus proche possible du couplage optique critique afin de maximiser le contraste du modulateur.

De manière préférentielle, comme illustré en figure 7, chaque résonateur est connecté électriquement à un résonateur adjacent selon la direction x par des connexions métalliques C de largeur très inférieure aux dimensions du résonateur, pour réduire la perturbation sur les modes électromagnétiques. Plus précisément, les connexions sont de largeur comprise entre 1/5 et 1/20 de la dimension caractéristique de la cavité (diagonale pour une cavité rectangulaire, côté pour une cavité carrée et diamètre pour une cavité circulaire). Alternativement, selon un autre mode de réalisation, chaque résonateur est connecté à un résonateur adjacent par des connexions selon la direction x et/ou selon la direction y.

La région active 4 peut être gravée ou non dans les régions non recouvertes par la couche 2.

Ce mode de réalisation permet une réduction de la constante RC du dispositif par la réduction de la surface de la couche métallique 2 et donc permet une augmentation de la vitesse de modulation.

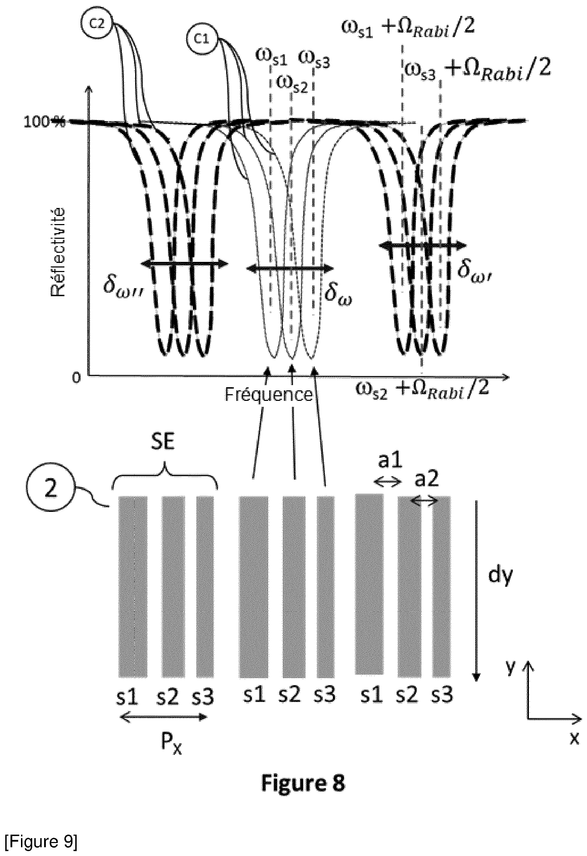

Dans un autre mode de réalisation illustré dans la figure 8, la couche métallique supérieure 2 est structurée de manière à permettre un fonctionnement du dispositif de modulation sur une bande spectrale élargie. Dans ce mode de réalisation, le dispositif fonctionne en régime non dispersif (L<$\lambda$/30). La couche supérieure 2 est structurée de manière à être constituée d'une pluralité de sous-ensembles SE identiques comprenant une pluralité de bandes métalliques de largeur $s_i$, différente des autres bandes du sous ensemble. Chaque bande est séparée d'une bande adjacente d'une distance $a_i$ selon la direction x. Le sous ensemble est répété avec périodicité Px selon la direction x. Dans l'exemple de la figure 8, à titre non limitatif, chaque sous ensemble comprend 3 bandes. Alternativement, selon un autre mode de réalisation, chaque sous ensemble comprend au moins deux bandes. Chaque bande métallique de largeur $s_i$ du sous ensemble forme un cavité semiconductrice avec la couche 4 et la couche 3 à laquelle est associée une absorption avec ou sans biais centrées à des fréquences ($\omega_{si}$ et $\omega_{si} + \Omega_{rabi}/2$) différentes de celles associées aux autres bandes.

La figure 8 en haut présente la réflectivité du dispositif en fonction de la frquence du rayonnement incident avec ou sans différence de tension appliquée. A biais zéro (différence de tension $V_0 = 0V$), l'absorption du dispositif correspondant à la somme des courbes C1, chacune associée à une bande du sous ensemble SE, est maximale sur une bande spectrale élargie $\delta\omega$ associée à l'absorption de la cavité semi-conductrice seule. L'absorption peut être ajustée/maximisée par simulations numériques en variant les paramètres $a_i$ et $s_i$ ainsi que l'épaisseur L de la couche semi-conductrice 4.

La largeur de la bande spectrale élargie $\delta\omega$ vaut environ $|\omega_{s\text{-max}} - \omega_{s\text{-min}}|$, avec $\omega_{s\_min}$, et $\omega_{s\_max}$ les fréquences de résonances associée respectivement aux bandes métalliques de largeur maximale ($s_{max}$) et minimale ($s_{min}$).

De même, pour un biais positif, (différence de tension $V_1 \neq 0V$), comme expliqué précédemment, l'absorption du dispositif correspondant à la somme des courbes C2, chacune associée à une bande du sous ensemble SE, est maximale sur les bande spectrale élargie δω' et δω" associées à l'absorption des puits quantiques et l'excitation de polaritons.

A cause de la dépendance de la fréquence d'excitation polaritonique en fonction de la fréquence de résonance de la cavité (reliée à la largeur $s_i$ des bandes), on a δω" < δω' < δω.

Ce mode de réalisation permet un fonctionnement large bande au dispositif de modulation car il est absorbant sur une plage élargie de fréquences δω pour une différence de tension nulle et sur une plage élargie de fréquences δω" et δω' pour une différence de tension positive.

Alternativement, dans un autre mode de réalisation, la couche supérieure métallique 2 est structurée dans les deux directions x et y, de manière similaire au mode de réalisation illustré en figure 8, formant ainsi des résonateurs 2D (cavité *patch*). Dans ce mode de réalisation, chaque cavité *patch* absorbe à une fréquence différente $\omega_{patch\_i}$, qui dépend de sa forme et dimension, qui est donc différente des autres cavité patch. Le résultat est - comme dans le mode de réalisation illustré dans la figure 8 dans laquelle la structuration est réalisée uniquement selon la direction y- le fonctionnement du modulateur sur une gamme de fréquence élargie.

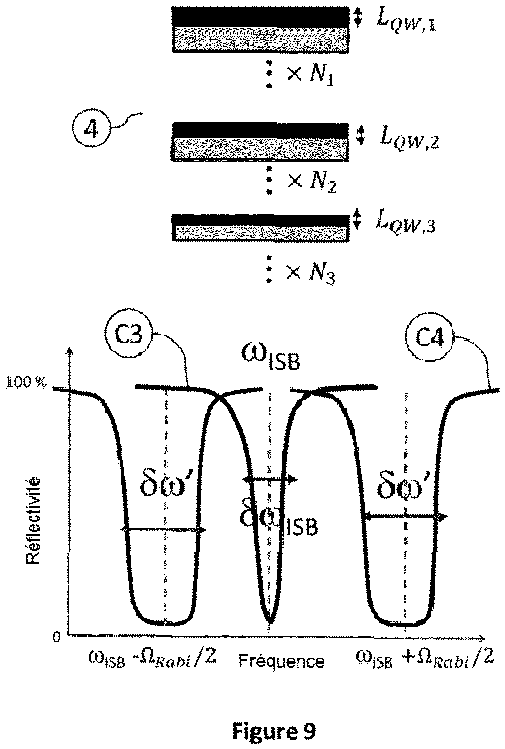

Dans un autre mode de réalisation, la couche semi-conductrice 4 comprend un empilement d'une pluralité de puits quantiques avec une épaisseur $L_{QW,i}$ de puits quantiques différent pour chaque période i, constituant ainsi un empilement de $N_{tot}$ périodes. A titre d'exemple non limitatif illustré dans la figure 9 en haut, il existe 3 épaisseurs différentes de puits quantiques $L_{QW1}$, $L_{QW,2}$ et $L_{QW,3}$. On a ainsi $N_1 + N_2 + N_3 = N_{tot}$ périodes, où $N_i$ est le nombre de périodes d'empilement de puits quantiques de chacune des i périodes qui donnent lieu à une absorption intersousbande à la fréquence $\omega_{ISB,i}$, différente pour chaque période i. Dans ce cas, le dopage dans les puits quantiques devra être multiplié par 3 pour obtenir une absorption à la fréquence de Rabi $\Omega_{Rabi}$ égale à celle qui aurait été obtenue avec un empilement de puits quantique d'une seule épaisseur. Alternativement, dans un autre mode de réalisation, un nombre différent de trois épaisseurs différentes pourra être utilisé. Dans le mode de réalisation de la figure 9 en haut, un seul puits quantique est utilisé pour chaque période. Alternativement, dans un autre mode de réalisation les puits quantiques de chaque période sont des puits couplés, comme dans le mode de réalisation de la figure 4.

La figure 9 en bas présente la réflectivité du dispositif en fonction de la fréquence du rayonnement incident avec ou sans différence de tension appliquée.

A biais zéro (différence de tension $V_0 = 0V$), la réflectivité du dispositif (courbe C3) est maximale à la fréquence de la cavité $\omega_{cav}$ associée à l'absorption de la cavité semi-conductrice seule. La largeur spectrale de l'absorption $\delta\omega_{ISB}$ est ici uniquement liée à la largeur de raie du mode de résonance $\delta E_{cav}$.

Pour un biais positif, (différence de tension $V_1 \neq 0V$), la réflectivité du dispositif (courbe C4) du dispositif est maximale sur deux gammes élargies de largeur δω', à approximativement $\omega_{cav} \pm \Omega_{Rabi}$, à cause de la pluralité de fréquence d'absorption intersousbande $\omega_{ISB,i}$, associée à chaque période i.

## Revendications

1. Dispositif (10, 100) de modulation de l'amplitude d'un rayonnement laser incident (1) sur ledit dispositif et présentant une longueur d'onde Ai **caractérisé en ce qu'**il comprend : une couche inférieure métallique (3) au-dessus de laquelle se trouve une couche semi-conductrice (4) qui contient un empilement d'une pluralité de puits quantiques, au-dessus de laquelle se trouve une couche supérieure métallique structurée (2), les deux couches métalliques (2, 3) étant réfléchissantes au rayonnement laser incident (1), la structuration de la couche supérieure et la distance entre lesdites deux couches métalliques L étant suffisamment petite pour que le dispositif forme une microcavité optique présentant au moins un mode de résonnance;

   au moins une partie des puis quantiques dits puits actifs présentant une absorption intersousbande à une longueur d'onde centrale $\lambda_{ISB} = hc/E_{ISB}$, le couplage entre ladite transition intersoubsande à ladite longueur d'onde centrale $\lambda_{ISB}$ et un des modes de la microcavité entrainant l'excitation de polaritons de cavités et un dédoublement de Rabi aux énergies $E_{ISB} \pm \hbar\Omega_{Rabi}$ avec $\Omega_{Rabi}$ la fréquence de Rabi ;

   ledit dispositif comprenant un circuit électrique (5) configuré pour appliquer deux différences de tension distinctes, $V_0$ et $V_1$ entre les deux couches métalliques, le dispositif (4) absorbant le rayonnement incident (1) pour la différence de tension $V_0$ et le dispositif réfléchissant ou transmettant le rayonnement incident pour la différence de tension $V_1$.

2. Dispositif selon la revendication précédente, dans lequel la couche métallique inférieure ne possède pas de discontinuités et le dispositif réfléchit le rayonnement incident pour la différence de tension $V_1$.

3. Dispositif selon l'une quelconques des revendications précédentes, dans lequel ladite couche supérieure métallique est formée d'une pluralité de bandes métalliques de largeur s, séparées d'une distance *a*, avec $s + a < \lambda_f/2$.

4. Dispositif selon la revendication précédente, dans lequel la largeur des bandes métallique s est telle que $s = \lambda_f/2.n$ à $\pm30\%$ avec *n* l'indice de ladite couche de semi-conducteur.

5. Dispositif selon la revendication 3, dans lequel la largeur des bandes métallique s = $\lambda_f/2$. *ns* est telle que $s = 3.\lambda_f/2.n$ à $\pm30\%$ avec *n* l'indice de ladite couche de semi-conducteur.

6. Dispositif selon l'une quelconque des revendications précédentes, dans lequel les contacts entre la couche semi-conductrice et les couches métalliques sont réalisés par des contacts Schottky ou par l'introduction de couches isolantes.

7. Dispositif selon la revendication précédente, dans lequel la distance entre lesdites deux couches métalliques L est égale à $\lambda_f/30$ à $\pm30\%$.

8. Dispositif selon la revendication précédente, dans lequel la distance entre les deux couches métalliques L est choisie par des simulations numériques de manière à ce que ledit dispositif fonctionne en régime non dispersif.

9. Dispositif (10) selon la revendication précédente, dans lequel les puits quantiques ou les barrières séparant les puits quantiques sont dopés électroniquement, les puits quantiques étant choisis pour que, pour une première différence de tension $V_0$ appliquée par ledit circuit électrique (5) entre lesdites deux couches métalliques, le dispositif présente une absorption aux énergies $E_{ISB} \pm \hbar\Omega_{Rabi}$ et non pas aux longueurs d'ondes égales aux modes de résonance de la cavité et pour que, pour une deuxième différence de tension $V_1$, tous les puits quantiques de la couche semi-conductrice sont dépeuplés de leurs charges, le dispositif présente une absorption aux modes de résonance de la cavité et non pas aux énergies $E_{ISB} \pm \hbar\Omega_{Rabi}$.

10. Dispositif selon la revendication précédente, dans lequel l'épaisseur de la couche semi-conductrice L est telle que $V_1$ est inférieure à la tension maximale supportée par les contacts entre la couche semi-conductrice et les couches métalliques.

11. Dispositif selon la revendication précédente, dans lequel l'épaisseur L de la couche semi-conductrice est choisie pour que $V_1$ soit inférieure à 10V.

12. Dispositif selon l'une quelconque des revendications 1 à 6, dans lequel la distance entre lesdites deux couches métalliques L est égale à $\lambda_f/10$ à $\pm30\%$.

13. Dispositif (100) selon l'une quelconque des revendications 1 à 7 et 8 à 11, dans lequel la couche semi-conductrice comprend un empilement de puits quantiques couplés constitués d'un puits étroit non dopé dit puits actif séparé par une première barrière d'un puits large dit réservoir, les puits quantiques couplés étant séparés les uns des autres d'une part une deuxième barrière plus large que ladite première barrière, la première barrière ou le réservoir de chaque puits quantiques couplés étant dopé électroniquement, les puits actifs étant choisis afin qu'ils présentent une absorption intersousbande à une longueur d'onde centrale $\lambda_{ISB}$ proche d'un mode de résonance de ladite microcavité optique; lesdits puits quantiques couplés étant adaptés pour que, pour une première différence de tension $V_0$ appliquée par ledit circuit électrique (5) entre lesdites deux couches métalliques, les charges provenant du dopage sont transférés par effet tunnel dans les puits étroits et le dispositif présente une absorption aux énergies $E_{ISB} \pm \hbar\Omega_{Rabi}$ et non pas aux longueurs d'ondes égales aux modes de résonance de la cavité, et pour que, pour une deuxième différence de tension $V_1$, le dispositif présente une absorption aux longueurs d'ondes égales aux modes de résonance de la cavité et non pas aux énergies $E_{ISB} \pm \hbar\Omega_{Rabi}$.

14. Dispositif selon la revendication précédente, dans lequel l'épaisseur L de la couche semi-conductrice est choisie pour que $V_0$ soit inférieure ou égale à 2V.

**15.** Dispositif selon l'une quelconque des revendications 2 à 12, dans lequel la couche semi-conductrice est structurée pour que les empilements de puits quantiques soient situés uniquement directement en dessous des bandes métalliques de la couche métallique supérieure.

**16.** Dispositif selon l'une quelconque des revendications précédentes, dans lequel les puits quantiques de la couche semi-conductrice sont réalisés en GaAs/AlGaAs ; InGaAs/AllnAs ; InAs/AlSb, Si/SiGe, GaN/AlGaN.

**17.** Dispositif selon l'une quelconque des revendications précédentes, dans lequel une dimension caractéristique du dispositif est inférieure à 200 $\mu$m.

**18.** Dispositif selon l'une quelconque des revendications 3 à 17, dans lequel la couche métallique inférieure présente des discontinuités et est structurée de manière à ce que ledit dispositif transmette le rayonnement incident pour la différence de tension $V_1$, ledit dispositif comprenant un substrat 8 transparent au rayonnement incident en dessous de la couche métallique inférieure et en contact avec cette dernière.


**Patentansprüche**

**1.** Vorrichtung (10, 100) zur Amplitudenmodulation von Laserstrahlung (1), die auf die Vorrichtung auftrifft und eine Wellenlänge $\lambda_i$ aufweist, **dadurch gekennzeichnet, dass** sie umfasst: eine untere Metallschicht (3), über der sich eine Halbleiterschicht (4) befindet, die eine Schichtung aus einer Vielzahl von Quantentöpfen enthält, über der sich eine strukturierte obere Metallschicht (2) befindet, wobei beide Metallschichten (2, 3) für die einfallende Laserstrahlung (1) reflektierend sind, wobei die Strukturierung der oberen Schicht und der Abstand zwischen den beiden Metallschichten L ausreichend klein ist, damit die Vorrichtung einen optischen Mikrohohlraum bildet, der mindestens einen Resonanzmodus aufweist;

wobei mindestens ein Teil der sogenannten aktiven Quantenschächte eine Intersubbandabsorption bei einer zentralen Wellenlänge $\lambda_{ISB} = hc/E_{ISB}$ aufweist, wobei die Kopplung zwischen dem Intersubbandübergang bei der zentralen Wellenlänge $\lambda_{ISB}$ und einen der Modi des Mikrohohlraums die Anregung von Hohlraumpolaritonen und eine Rabi-Spaltung bei den Energien $E_{ISB} \pm \hbar\Omega_{Rabi}$ bewirkt, wobei $\Omega_{Rabi}$ die Rabi-Frequenz ist; wobei die Vorrichtung eine elektrische Schaltung (5) umfasst, die so konfiguriert ist, dass sie zwei verschiedene Spannungsdifferenzen, $V_0$ und $V1$, zwischen den beiden Metallschichten anlegt, wobei die Vorrichtung (4) die einfallende Strahlung (1) für die Spannungsdifferenz $V_0$ absorbiert und die Vorrichtung die einfallende Strahlung für die Spannungsdifferenz $V_1$ reflektiert oder überträgt.

**2.** Vorrichtung nach dem vorhergehenden Anspruch, in der die untere Metallschicht keine Unterbrechungen aufweist und die Vorrichtung die einfallende Strahlung für die Spannungsdifferenz $V_1$ reflektiert.

**3.** Vorrichtung nach einem der vorhergehenden Ansprüche, in der die obere Metallschicht aus einer Vielzahl von Metallstreifen mit einer Breite s gebildet wird, die durch einen Abstand $\alpha$ getrennt sind, wobei $s + \alpha < \lambda_i/2$ gilt.

**4.** Vorrichtung nach dem vorhergehenden Anspruch, in der die Breite der Metallstreifen s so ist, dass $s = \lambda_i / 2.n$ bei $\pm 30\%$ mit $n$ dem Index der Halbleiterschicht.

**5.** Vorrichtung nach Anspruch 3, in der die Breite der Metallstreifen $s = \lambda_i/2.ns$ so ist, dass $s = 3.\lambda_i/2.ns$ bei $\pm 30\%$, mit $n$ dem Index der Halbleiterschicht.

**6.** Vorrichtung nach einem der vorhergehenden Ansprüche, in der die Kontakte zwischen der Halbleiterschicht und den Metallschichten durch Schottky-Kontakte oder durch das Einbringen von Isolierschichten hergestellt werden.

**7.** Vorrichtung nach dem vorhergehenden Anspruch, in der der Abstand zwischen den beiden Metallschichten L gleich $\lambda_i/30$ bei $\pm 30\%$ ist.

**8.** Vorrichtung nach dem vorhergehenden Anspruch, in der der Abstand zwischen den beiden Metallschichten L durch numerische Simulationen so gewählt wird, dass die Vorrichtung in einem nicht-dispersiven Regime arbeitet.

**9.** Vorrichtung (10) nach dem vorhergehenden Anspruch, in der die Quantentöpfe oder die Barrieren, die die Quantentöpfe trennen, elektronisch dotiert sind, wobei die Quantentöpfe so gewählt sind, dass für eine erste Spannungsdifferenz $V_0$, die von der elektrischen Schaltung (5) zwischen den beiden Metallschichten angelegt wird, die Vorrichtung eine Absorption bei den Energien $E_{ISB} \pm \hbar\Omega_{Rabi}$ und nicht bei Wellenlängen gleich den Resonanzmodi des Hohlraums aufweist und damit für eine zweite Spannungsdifferenz $V_1$ alle Quantentöpfe der Halbleiterschicht von ihren Ladungen entleert werden, wobei die Vorrichtung eine Absorption bei den Resonanzmodi des Hohlraums und nicht bei den Energien $E_{ISB} \pm \hbar\Omega_{Rabi}$ aufweist.

**10.** Vorrichtung nach dem vorhergehenden Anspruch, in der die Dicke der Halbleiterschicht $L$ so ist, dass $V_1$ kleiner ist als die maximale Spannung, die von den Kontakten zwischen der Halbleiterschicht und den Metallschichten vertragen wird.

**11.** Vorrichtung nach dem vorhergehenden Anspruch, in der die Dicke $L$ der Halbleiterschicht so gewählt ist, dass $V_1$ kleiner als 10V ist.

**12.** Vorrichtung nach einem der Ansprüche 1 bis 6, in der der Abstand zwischen den beiden Metallschichten L gleich $\lambda_i/10$ bei $\pm$ 30% ist.

**13.** Vorrichtung (100) nach einem der Ansprüche 1 bis 7 und 8 bis 11, in der die Halbleiterschicht eine Schichtung gekoppelter Quantentöpfe umfasst, die aus einem nicht dotierten schmalen Topf, dem sogenannten aktiven Topf, besteht, der durch eine erste Barriere von einem breiten Topf, dem sogenannten Reservoir, getrennt ist, wobei die gekoppelten Quantentöpfe voneinander zudem durch eine zweite Barriere getrennt sind, die breiter ist als die erste Barriere, wobei die erste Barriere oder das Reservoir jedes gekoppelten Quantentopfes elektronisch dotiert ist und die aktiven Töpfe so ausgewählt werden, dass sie eine Intersubbandabsorption bei einer Zentralwellenlänge $\lambda_{ISB}$ nahe eines Resonanzmodus des optischen Mikrohohlraums aufweisen; wobei die gekoppelten Quantentöpfe so ausgelegt sind, dass bei einer ersten Spannungsdifferenz $V_0$, die von der elektrischen Schaltung (5) zwischen den beiden Metallschichten angelegt wird, die Ladungen aus der Dotierung durch Tunneleffekt in die schmalen Töpfe übertragen werden und die Vorrichtung eine Absorption bei Energien $E_{ISB} \pm \hbar\Omega_{Rabi}$ und nicht bei Wellenlängen aufweist, die gleich den Resonanzmodi des Hohlraums ist, und damit bei einer zweiten Spannungsdifferenz $V_1$ die Vorrichtung eine Absorption bei Wellenlängen gleich den Resonanzmodi des Hohlraums und nicht bei Energien $E_{ISB} \pm \hbar\Omega_{Rabi}$ aufweist.

**14.** Vorrichtung nach dem vorhergehenden Anspruch, in der die Dicke $L$ der Halbleiterschicht so gewählt ist, dass $V_0$ kleiner gleich 2V ist.

**15.** Vorrichtung nach einem der Ansprüche 2 bis 12, in der die Halbleiterschicht so strukturiert ist, dass die Quantentopfschichtungen nur direkt unter den Metallstreifen der oberen Metallschicht liegen.

**16.** Vorrichtung nach einem der vorhergehenden Ansprüche, in der die Quantentöpfe der Halbleiterschicht aus GaAs/AlGaAs; InGaAs/AlInAs; InAs/AlSb, Si/SiGe, GaN/AlGaN hergestellt sind.

**17.** Vorrichtung nach einem der vorhergehenden Ansprüche, in der eine charakteristische Größe der Vorrichtung weniger als 200 $\mu$m beträgt.

**18.** Vorrichtung nach einem der Ansprüche 3 bis 17, in der die untere Metallschicht Diskontinuitäten aufweist und so strukturiert ist, dass die Vorrichtung die einfallende Strahlung für die Spannungsdifferenz $V_1$ überträgt, wobei die Vorrichtung ein Substrat 8 umfasst, das unterhalb der unteren Metallschicht und in Kontakt mit dieser für die einfallende Strahlung transparent ist.

**Claims**

**1.** A device (10, 100) for modulating the amplitude of an incident laser radiation (1) on said device and having a

wavelength $\lambda_i$, **characterized in that** it comprises: a metal bottom layer (3) above which there is a semiconductive layer (4) which contains a stack of a plurality of quantum wells, above which there is a structured metal top layer (2), the two metal layers (2, 3) being reflective to the incident laser radiation (1), the structuring of the top layer and the distance between said two metal layers L being small enough for the device to form an optical microcavity having at least one resonance mode;

at least a part of the quantum wells, called active wells, having an intersubband absorption at a central wavelength $\lambda_{ISB} = hc/E_{ISB}$, the coupling between said intersubband transition at said central wavelength $\lambda_{ISB}$ and one of the modes of the microcavity driving the excitation of cavity polaritons and a Rabi splitting at the energies $E_{ISB} \pm \hbar\Omega_{Rabi}$ with $\Omega_{Rabi}$ the Rabi frequency;

said device comprising an electric circuit (5) configured to apply two distinct voltage differences, $V_0$ and $V_1$, between the two metal layers, the device (4) absorbing the incident radiation (1) for the voltage difference $V_0$ and the device reflecting or transmitting the incident radiation for the voltage difference $V_1$.

2. The device as claimed in the preceding claim, wherein the metal bottom layer does not have discontinuities and the device reflects the incident radiation for the voltage difference $V_1$.

3. The device as claimed in either one of the preceding claims, wherein said metal top layer is formed by a plurality of metal strips of width s, separated by a distance *a*, with $s + a < \lambda_i/2$.

4. The device as claimed in the preceding claim, wherein the width of the metal strips s is such that s = $\lambda_i/2.n$ to $\pm30\%$ with *n* the index of said semiconductive layer.

5. The device as claimed in claim 3, wherein the width of the metal strips $s = \lambda_i/2.ns$ is such that s = $3.\lambda_i/2.n$ to $\pm30\%$ with *n* the index of said semiconductive layer.

6. The device as claimed in any one of the preceding claims, wherein the contacts between the semiconductive layer and the metal layers are produced by Schottky contacts or by the introduction of insulating layers.

7. The device as claimed in the preceding claim, wherein the distance between said two metal layers L is equal to $\lambda_i/30$ to $\pm30\%$.

8. The device as claimed in the preceding claim, wherein the distance between the two metal layers L is chosen by digital simulations so that said device operates in non-dispersive regime.

9. The device (10) as claimed in the preceding claim, wherein the quantum wells or the barriers separating the quantum wells are electronically doped, the quantum wells being chosen so that, for a first voltage difference $V_0$ applied by said electric circuit (5) between said two metal layers, the device exhibits an absorption to the energies $E_{ISB} \pm \hbar\Omega_{Rabi}$ and not to the wavelengths equal to the resonance modes of the cavity and so that, for a second voltage difference $V_1$, all the quantum wells of the semiconductive layer are depopulated of their charges, the device exhibits an absorption to the cavity resonance modes and not to the energies $E_{ISB} \pm \hbar\Omega_{Rabi}$.

10. The device as claimed in the preceding claim, wherein the thickness of the semiconductive layer L is such that $V_1$ is less than the maximum voltage supported by the contacts between the semiconductive layer and the metal layers.

11. The device as claimed in the preceding claim, wherein the thickness L of the semiconductive layer is chosen so that $V_1$ is less than 10V.

12. The device as claimed in any one of claims 1 to 6, wherein the distance between said two metal layers L is equal to $\lambda_i/10$ to $\pm30\%$.

13. The device (100) as claimed in any one of claims 1 to 7 and 8 to 11, wherein the semiconductive layer comprises a stack of coupled quantum wells composed of a non-doped narrow well, called active well, separated by a first barrier from a wide well, called reservoir, the coupled quantum wells being separated from one another on another side a second barrier wider than said first barrier, the first barrier or the reservoir of each coupled quantum well being electronically doped, the active wells being chosen in order for them to exhibit an intersubband absorption at a central wavelength $\lambda_{ISB}$ close to a resonance mode of said optical microcavity;

said coupled quantum wells being adapted so that, for a first voltage difference $V_0$ applied by said electric circuit (5) between said two metal layers, the charges originating from the doping are transferred by tunnel effect into the narrow wells and the device exhibits an absorption to the energies $E_{ISB} \pm \hbar\Omega_{Rabi}$ and not to the wavelengths equal to the resonance modes of the cavity, and so that, for a second voltage difference $V_1$, the device exhibits an absorption to the wavelengths equal to the resonance modes of the cavity and not to the energies $E_{ISB} \pm \hbar\Omega_{Rabi}$.

14. The device as claimed in the preceding claim, wherein the thickness $L$ of the semiconductive layer is chosen so that $V_0$ is less than or equal to 2V.

15. The device as claimed in any one of claims 2 to 12, wherein the semiconductive layer is structured so that the stacks of quantum wells are situated only directly below the metal strips of the metal top layer.

16. The device as claimed in any one of the preceding claims, wherein the quantum wells of the semiconductive layer are produced in GaAs/AlGaAs; InGaAs/AllnAs; InAs/AlSb, Si/SiGe, GaN/AlGaN.

17. The device as claimed in any one of the preceding claims, wherein a characteristic dimension of the device is less than 200 $\mu$m.

18. The device as claimed in any one of claims 3 to 17, wherein the metal bottom layer has discontinuities and is structured so that said device transmits the incident radiation for the voltage difference $V_1$, said device comprising a substrate 8 that is transparent to the incident radiation below the metal bottom layer and in contact therewith.

[Figure 1]

Figure 1

[Figure 2]

Figure 2

[Figure 3]

Figure 3

[Figure 4]

Figure 4

[Figure 5]

$$\omega_{cav} = \omega_{ISB}$$
$$\omega_{ISB} + \Omega_{rabi}/2$$

Figure 5

EP 3 948 409 B1

[Figure 6]

Figure 6

21

[Figure 7]

Figure 7

**Figure 8**

[Figure 9]

Figure 9

## RÉFÉRENCES CITÉES DANS LA DESCRIPTION

**Littérature non-brevet citée dans la description**

- **NEVOU, L. et al.** Short-wavelength intersubband electroabsorption modulation based on électron tunneling between GaN/AIN coupled quantum wells. *Applied Physics Letters,* 2007, vol. 90 (22), 223511
- **MACHHADANI, H. et al.** GaN/AlGaN intersubband optoelectronic devices. *New Journal of Physics,* 2009, vol. 11 (12), 125023

- **LEE, J. et al.** Ultrafast Electrically Tunable Polaritonic Metasurfaces. *Advanced Optical Materials,* 2014, vol. 2 (11), 1057-1063
- **CRISTIANO CIUTI et al.** *Quantum vacuum properties of the intersubband cavity polariton field,* 2005